# EUROPEAN PATENT APPLICATION

(11) **EP 4 597 255 A1**
(43) Date of publication of application: **06.08.2025**
(21) Application number: 25150368.6
(22) Date of filing: 06.01.2025
(51) Int. Cl.: G06F 1/16, G06F 1/20, H05K 7/20

(54) **ELECTRONIC APPARATUS**

(30) Priority: 02.02.2024 JP 2024015031
(71) Applicant: Lenovo (Singapore) Pte. Ltd, New Tech Park 556741 (SG)
(72) Inventor: SAIGUSA, Yuki, Yokohama-shi, 220-0012 (JP); WANG, Hao-Yu, Yokohama-shi, 220-0012 (JP); YOSHIZAWA, Hajime, Yokohama-shi, 220-0012 (JP); NAKAGAKI, Yoshihito, Yokohama-shi, 220-0012 (JP); NAKADA, Kazuo, Yokohama-shi, 220-0012 (JP)
(74) Representative: Openshaw & Co.

(57) **Abstract**

An object of the present disclosure is to provide an electronic apparatus capable of improving appearance quality while securing cooling performance. The electronic apparatus includes: a chassis; and a fan which is provided in the chassis and has a suction surface with a suction port formed therein, wherein the chassis has a projecting part which is provided in such a manner as to protrude from a bottom surface and extends along a width direction, the projecting part has a vertical wall which extends in a longitudinal direction thereof, the vertical wall has a vent formed therein, and the suction surface is placed, facing an inner space of the projecting part.

## Description

### BACKGROUND OF THE INVENTION

### Field of the Invention

The present invention relates to an electronic apparatus provided with fans.

### Description of the Related Art

An electronic apparatus such as a laptop PC includes a heat generating element such as a CPU. This type of electronic apparatus has a configuration in which a fan is installed in a chassis to absorb the heat generated by a heat generating element and dissipates the absorbed heat to the outside (refer to, for example, Japanese Patent No. 7104832) .

### SUMMARY OF THE INVENTION

A conventional electronic apparatus is usually configured to include an intake port with a plurality of slit-shaped openings arranged in the bottom surface of a chassis, thereby drawing in outside air by fans through the above-mentioned intake port. Therefore, such a configuration makes the intake port in the bottom surface noticeable when, for example, carrying the electronic apparatus or using the apparatus in an upright position, thus deteriorating the appearance quality. On the other hand, there is a concern that simply eliminating the intake port in the bottom surface to improve the design reduces the intake efficiency and the air volume of the fans, resulting in deteriorated cooling performance.

The present invention has been made in view of the problem with the above-described prior part, and it is an object of the invention to provide an electronic apparatus capable of improving appearance quality while securing cooling performance.

An electronic apparatus according to one aspect of the present invention includes: a chassis; and a fan which is provided in the chassis and has a suction surface with a suction port formed therein, wherein the chassis has a projecting part which is provided in such a manner as to protrude from a bottom surface thereof and extends along a width direction, the projecting part has a vertical wall which extends along a longitudinal direction thereof, the vertical wall has a vent formed therein, and the suction surface is placed, facing an inner space of the projecting part.

According to the above-described aspect of the present invention, appearance quality can be improved while securing cooling performance.

### BRIEF DESCRIPTION OF THE DRAWINGS

FIG. 1 is a schematic plan view of an electronic apparatus according to an embodiment observed from above.
FIG. 2 is a plan view schematically illustrating the internal structure of a chassis.
FIG. 3 is a perspective view of the bottom surface of the chassis observed obliquely from the rear.
FIG. 4 is a perspective view of the bottom surface of the chassis observed obliquely from the front.
FIG. 5 is a side view of the electronic apparatus.
FIG. 6 is a side sectional view schematically illustrating the internal structure of the chassis including a cooling module and the peripheral area thereof.
FIG. 7 is a front sectional view schematically illustrating the internal structure of the chassis including the cooling module and the peripheral area thereof.
FIG. 8 is a table illustrating the results of simulation experiments comparing the cooling performance of electronic apparatus and the surface temperatures of the chassis when cooling modules having different configurations are installed in the chassis.

### DETAILED DESCRIPTION OF THE INVENTION

The following will describe in detail a preferred embodiment of an electronic apparatus according to the present invention with reference to the accompanying drawings.

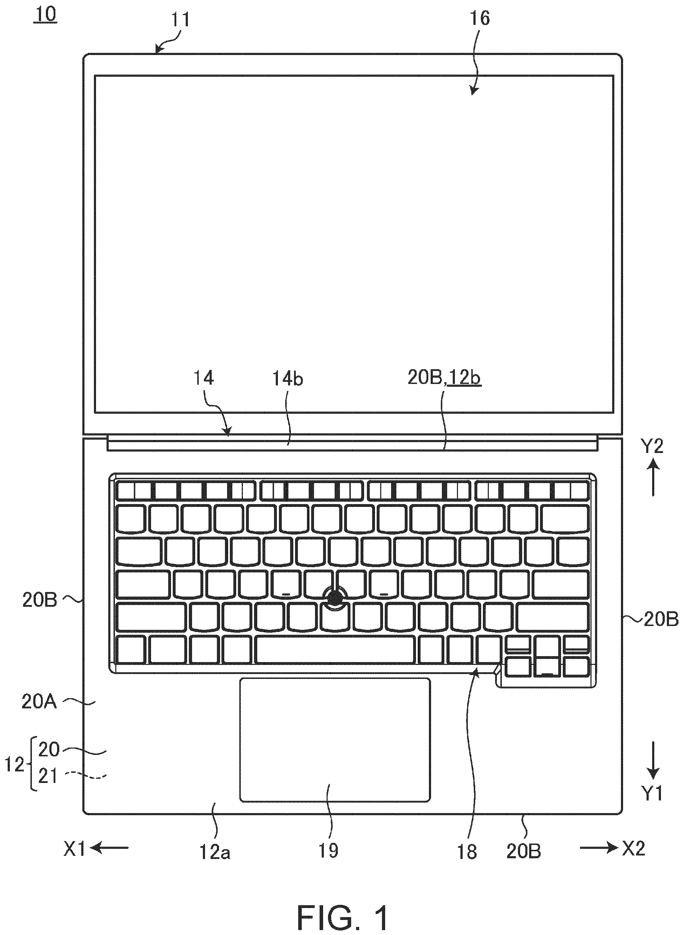

FIG. 1 is a schematic plan view of an electronic apparatus 10 according to an embodiment observed from above. As illustrated in FIG. 1, the electronic apparatus 10 of the present embodiment is a clamshell laptop PC. The electronic apparatus 10 has a configuration in which a cover body 11 and a chassis 12 are connected by a hinge 14 so as to be rotatable relative to each other. Although the present embodiment illustrates the electronic apparatus 10 as a laptop PC, the electronic apparatus may alternatively be, for example, a tablet PC, a smartphone, or a portable game machine other than the laptop PC.

The cover body 11 is a thin, flat, box-shaped chassis. The cover body 11 is provided with a display 16. The display 16 is, for example, an organic EL display or a liquid crystal display.

The chassis 12 is a thin, flat box body. A keyboard device 18 and a touchpad 19 are exposed on the upper surface (a surface 12a) of the chassis 12. Hereinafter, the chassis 12 and the components installed therein will be described using the posture of an operator operating the keyboard device 18 as the reference, with the width direction (left and right) of the chassis 12 being referred to as X1 and X2 directions, respectively, the depth direction (front and rear) of the chassis 12 being referred to as Y1 and Y2 directions, respectively, and the thickness direction (top and bottom) of the chassis 12 being referred to as Z1 and Z2 directions, respectively. The X1 and X2 directions may be collectively referred to as the X-direction, and similarly, the Y1 and Y2 directions and the Z1 and Z2 directions may be referred to as the Y-direction and a Z-direction, respectively. These directions are defined for the convenience of explanation, and may of course change, depending on the usage state, the installation attitude, or the like of the electronic apparatus 10.

The chassis 12 is composed of a chassis member 20, which forms the upper surface and the four peripheral side surfaces, and a cover member 21 forming the lower surface. The chassis member 20 has vertical walls 20B formed on the four peripheral edges of a cover plate 20A, which forms the surface 12a of the chassis 12. Thus, the chassis member 20 has a substantially bathtub shape with an open bottom. The cover member 21 has a substantially flat plate shape, and serves as a cover that closes the open bottom of the chassis member 20. The chassis member 20 and the cover member 21 are overlapped in the thickness direction and connected in a mutually detachable manner. The vertical walls 20B may be formed on the cover member 21. In this case, the chassis member 20 may be composed of only the cover plate 20A.

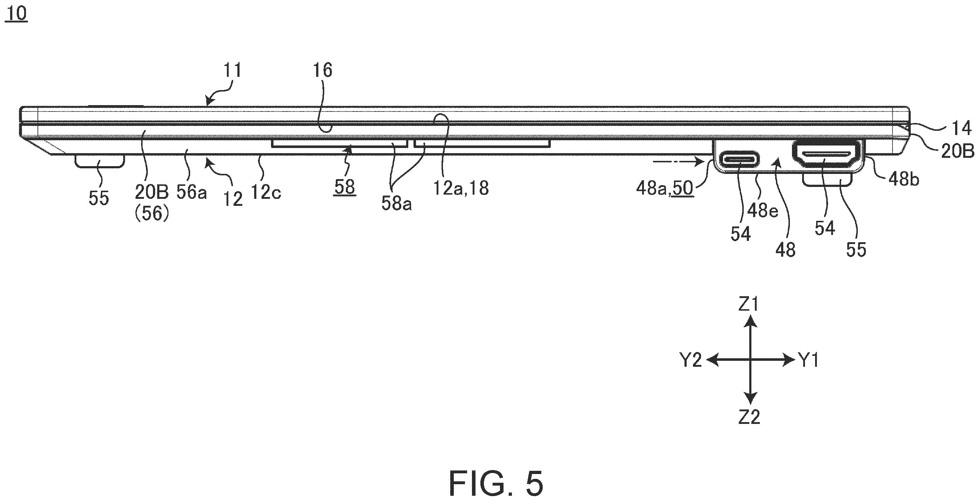

The hinge 14 is installed in a concave hinge placement groove 12b formed at the rear edge of the chassis 12, and connects the chassis 12 and the cover body 11. The hinge 14 has a structure in which, for example, a hinge shaft 14a serving as a rotating shaft is supported at both ends of a hinge chassis 14b in the longitudinal direction (refer to FIG. 5). The hinge 14 of the present embodiment is configured to have a so-called one-bar shape, with the hinge chassis 14b extending along the longitudinal direction of the hinge placement groove 12b. The hinge chassis 14b of the hinge 14 descends diagonally backward while rotating together with the cover body 11 (refer to FIG. 5). The hinge 14 has a structure that increases the rotation angle of the cover body 11 as described above, which is a so-called drop-down structure. The structure of the hinge 14 may be other than the one described above.

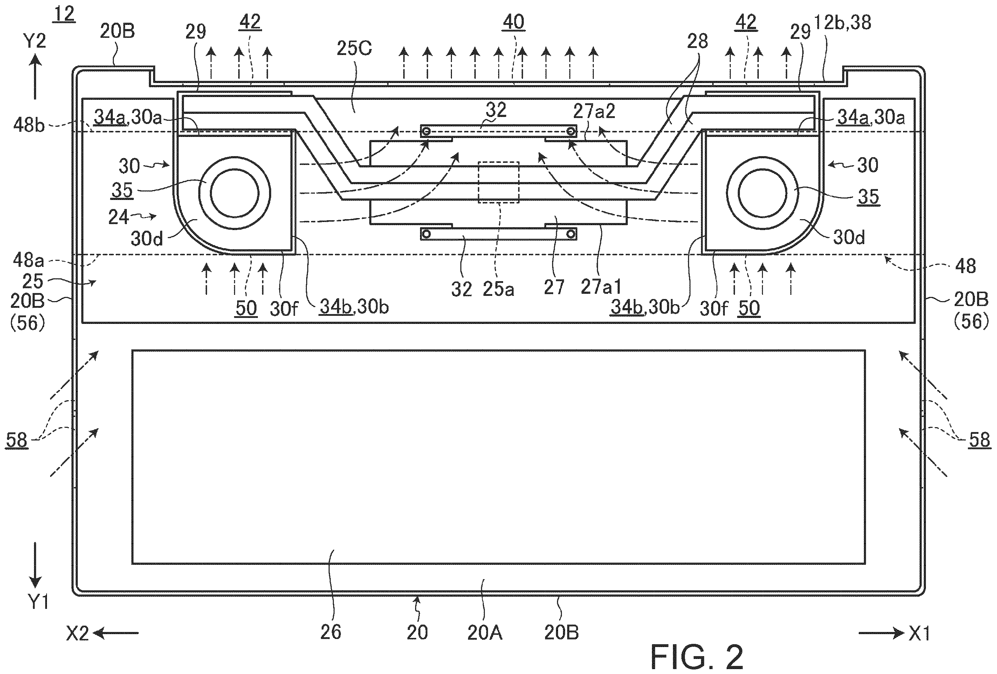

FIG. 2 is a plan view schematically illustrating the internal structure of the chassis 12. FIG. 2 is a diagram illustrating the interior of the chassis member 20 with the cover member 21 removed, which is observed from below.

As illustrated in FIG. 2, the chassis 12 includes therein a cooling module 24, a motherboard 25, and a battery device 26. Further, various electronic components, mechanical components, and the like are provided inside the chassis 12.

The motherboard (board) 25 is a circuit board serving as the main board of the electronic apparatus 10. The motherboard 25 is placed closer to a Y2 side in the chassis 12 and extends in an X-direction. The battery device 26 is a rechargeable battery that serves as a power source for the electronic apparatus 10. The battery device 26 is placed closer to a Y1 side relative to the motherboard 25 and extends in the X-direction.

The motherboard 25 of the present embodiment has a CPU (Central Processing Unit) 25a mounted thereon. In addition to the CPU 25a, the motherboard 25 can also be provided with various electronic components such as a GPU (Graphics Processing Unit), memories, and a communication module.

For example, an upper surface (a first surface 25A) of the motherboard 25 serves as the surface of attachment to the chassis member 20, and a lower surface (a second surface 25B) serves as a mounting surface for the CPU 25a and the like.

A description will now be given of a configuration example of the cooling module 24.

The CPU 25a is a heat generating element that generates the largest amount of heat among the electronic components mounted in the chassis 12. The cooling module 24 can absorb and diffuse the heat generated by the CPU 25a and discharge the heat to the outside of the chassis 12. The cooling module 24 may be configured to cool a heat generating element, such as a GPU, other than the CPU 25a.

As illustrated in FIG. 2, the cooling module 24 of the present embodiment includes a metal plate 27, heat pipes 28, a pair of heat sinks 29, 29, and a pair of fans 30, 30.

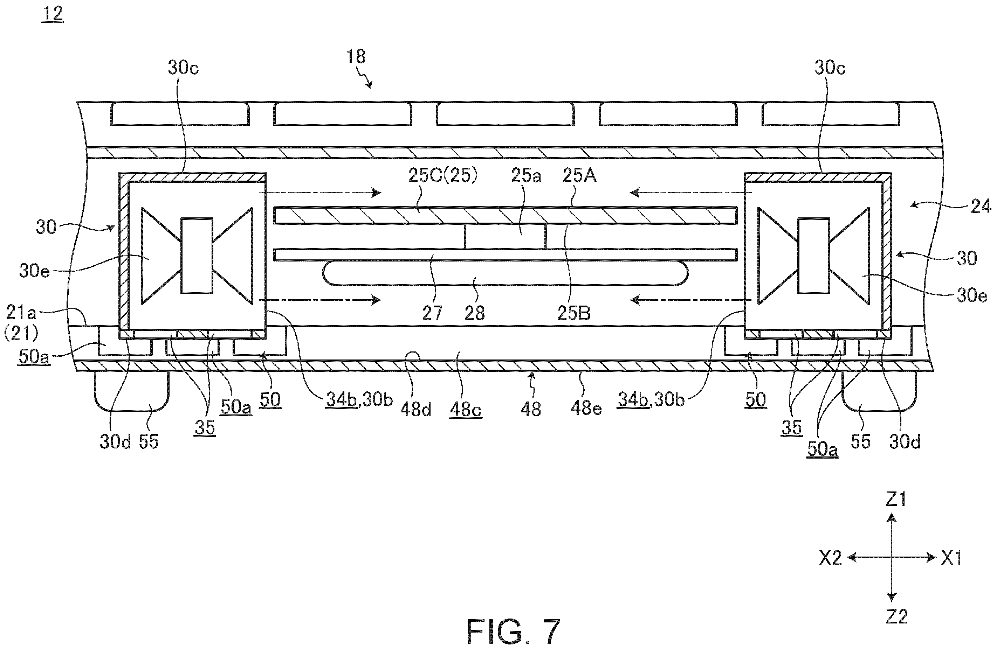

The metal plate 27 is a thin plate made of a metal such as copper, aluminum, or the like having high thermal conductivity. The metal plate 27 of the present embodiment is a copper plate. The metal plate 27 extends in the X-direction between the left and right fans 30, 30. Thus, the metal plate 27 covers a part (a part 25C) of the motherboard 25 placed between the left and right fans 30, 30, and the CPU 25a, which is mounted on the part 25C, from the second surface 25B side (a Z2 side)(refer also to FIG. 7). The metal plate 27 functions as a heat diffusion member, which absorbs and diffuses the heat from the CPU 25a or the like. The metal plate 27 is connected to the surface of the CPU 25a. Thermally conductive grease and a copper block or the like having approximately the same size as the outer shape of the CPU 25a, for example, are interposed between the metal plate 27 and the CPU 25a. Leaf springs 32 are attached to edges 27a1 and 27a2 along the X-direction of the metal plate 27. The leaf springs 32 are components that press the metal plate 27 against the CPU 25a.

The heat pipes 28 are pipe-type heat transport devices. The heat pipes 28 are configured of metal pipes thinly and flatly collapsed to form elliptical cross sections, and configured by sealing a working fluid into a sealed space inside. Examples of the working fluid include water, alternative fluorocarbons, acetone, and butane. The heat pipes 28 can be used, for example, in a set of two. The longitudinal central parts of the heat pipes 28 are fixed to the back of the surface of connection of the metal plate 27 to the CPU 25a. Both ends of the heat pipes 28 are fixed to the surfaces on the Z2 side of the left and right heat sinks 29. The longitudinal central part of each of the heat pipes 28 overlaps the CPU 25a in the Z-direction. This enables the heat pipes 28 to efficiently receive the heat of the CPU 25a, which has been transferred to the metal plate 27, and transport the received heat to the heat sinks 29 at both ends with high efficiency.

The heat sinks 29 have a structure in which a plurality of fins formed of thin metal plates are arranged at equal intervals in the X-direction. The fins stand in the Z-direction on a predetermined base plate and extend in the Y-direction. A gap is formed between adjacent fins of the heat sinks 29 through which air sent from the fans 30 passes. The heat sinks 29 are formed of a metal having high thermal conductivity such as aluminum or copper. The heat sinks 29 are placed so as to face side surfaces 30a (discharge ports 34a) on the Y2 side of the fans 30.

The pair of fans 30, 30 are placed in the X-direction with the metal plate 27 located therebetween, and face each other. Each of the fans 30 has the discharge port 34a in a side surface 30a on the Y2 side. Each of the discharge ports 34a is close to and opposed to the heat sink 29 therebehind. The fans 30 can have discharge ports 34b in the side surfaces 30b opposing each other. The discharge ports 34b, 34b of the left and right fans 30 face each other with the metal plate 27 located therebetween. In each of the fans 30, of upper and lower end surfaces 30c and 30d facing in the Z-direction, at least the end surface 30d on the Z2 side has a suction port 35. The suction port 35 can be provided also in the end surface 30c on a Z1 side. The end surfaces 30c and 30d are surfaces that are orthogonal to the side surfaces 30a and 30b, and also orthogonal to the axial direction of the rotating shafts of impellers 30e.

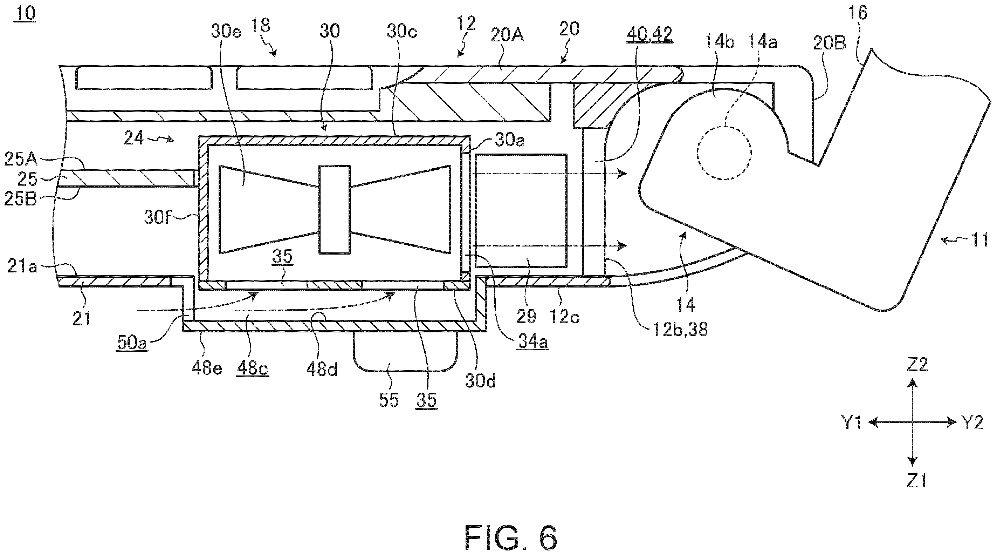

The fans 30 are centrifugal fans that, by motors, rotate the impellers 30e accommodated in housings (refer to FIG. 6). Thus, the fans 30 can discharge, through the discharge ports 34a and 34b, the air drawn in through the suction ports 35.

A description will now be given of an intake/exhaust structure for introducing air into the chassis 12 by the fans 30 and exhausting the air discharged from the fans 30 to the outside of the chassis 12.

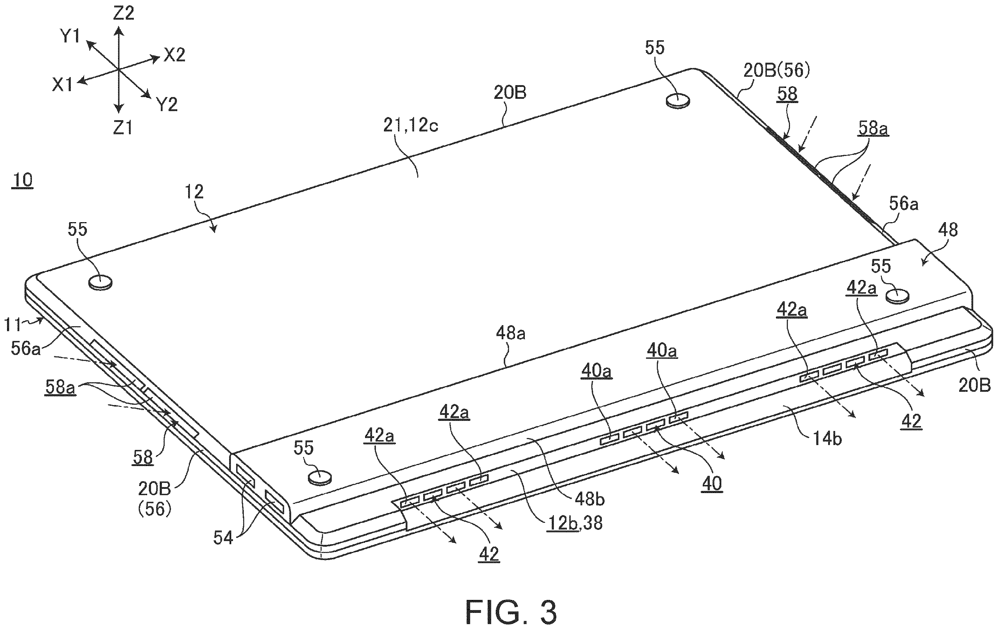

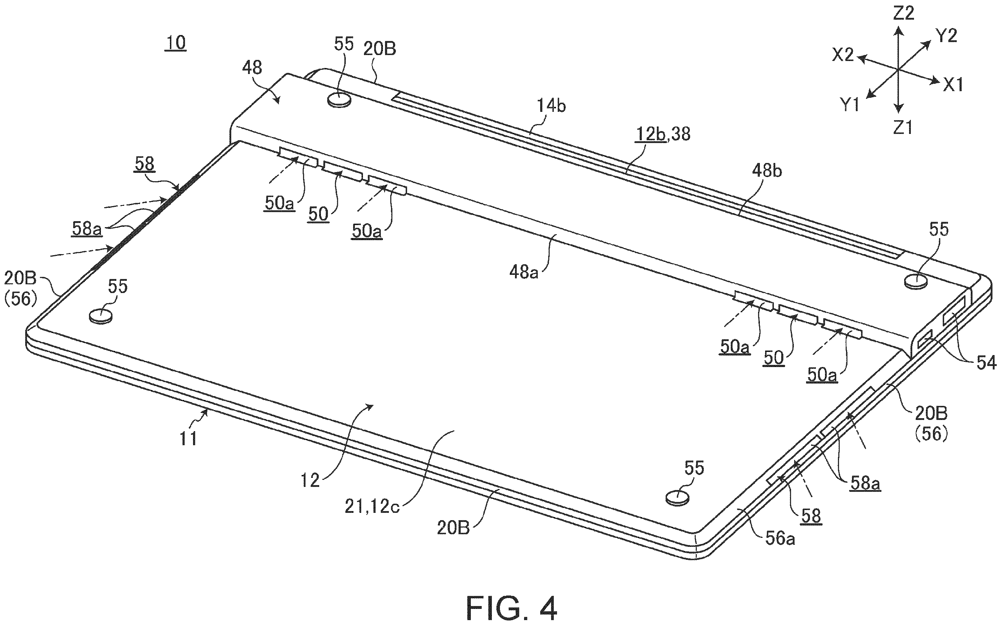

FIG. 3 is a perspective view of a bottom surface 12c of the chassis 12 observed obliquely from the rear. FIG. 4 is a perspective view of the bottom surface 12c of the chassis 12 observed obliquely from the front. FIG. 5 is a side view of the electronic apparatus 10. FIG. 6 is a side sectional view schematically illustrating the internal structure of the chassis 12 including the cooling module 24 and a peripheral area thereof. FIG. 7 is a front sectional view schematically illustrating the internal structure of the chassis 12 including the cooling module 24 and the peripheral area thereof.

As illustrated in FIG. 2 to FIG. 6, the exhaust structure of the electronic apparatus 10 can include exhaust ports 40 and 42 formed in a vertical wall 20B (an outer wall 38) at the rear edge (the edge on the Y2 side) of the chassis 12. The exhaust port 40 is an opening for exhausting, to the outside of the chassis 12, the air (hot air) that has been discharged through the discharge ports 34b of the fans 30 and cooled while passing along the surface of the metal plate 27. The exhaust port 42 is an opening for exhausting, to the outside of the chassis 12, the air (hot air) that has been discharged through the discharge ports 34a of the fans 30 and cooled while passing along the heat sinks 29.

In the case of the present embodiment, the vertical wall 20B on the Y2 side extends along the longitudinal direction thereof, and has a hinge placement groove 12b, which is recessed on the Y1 side. The outer wall 38 is the bottom wall (the front wall) of the hinge placement groove 12b.

The exhaust port 40 is provided in the vicinity of the center of the outer wall 38 in the longitudinal direction. The exhaust port 40 consists of, for example, a plurality of (four in FIG. 3) openings 40a arranged closely in the X-direction. The exhaust port 40 is positioned between the fans 30, 30 when the placement direction of the left and right fans 30, 30 (the X-direction) is used as the reference. The metal plate 27 extends in the X-direction at a position close to the outer wall 38. Thus, the exhaust port 40 is close to and opposed to the edge 27a2 of the metal plate 27 on the Y2 side.

The exhaust ports 42 are flush with the exhaust port 40 and formed in the outer wall 38. Each of the exhaust ports 42 consists of, for example, a plurality of (four in FIG. 3) openings 42a closely arranged in the X-direction. The exhaust ports 42 are provided in a pair, and placed with the exhaust port 40 located therebetween in the longitudinal direction of the outer wall 38. The exhaust ports 42 are opposed closely to the left and right heat sinks 29, 29 on the Y2 side, and located in the vicinity of the left and right ends of the outer wall 38.

The vertical wall 20B can be configured without the hinge placement groove 12b. In this case, the exhaust ports 40 and 42 may be formed in the vertical wall 20B itself, which is an outer wall.

As illustrated in FIG. 2 to FIG. 7, the intake structure of the electronic apparatus 10 includes vents 50 formed in the projecting part 48 provided on the bottom surface 12c of the chassis 12.

The projecting part 48 protrudes from the bottom surface 12c. The projecting part 48 is shaped like a square tube which is lengthy in the X-direction and flat in the Z-direction. The length of the projecting part 48 in the X-direction is approximately equivalent to the full width of the chassis 12 in the X-direction. The projecting part 48 is provided at a position closer to the Y2 side in the front-rear direction (the Y-direction) of the bottom surface 12c. The projecting part 48 has a pair of vertical walls 48a and 48b extending along the longitudinal direction (the X-direction) thereof. The vertical wall 48b on the Y2 side is located at the immediate front of the outer wall 38. In a plan view of the chassis 12, the projecting part 48 is placed at a position where the projecting part 48 vertically overlaps the left and right fans 30, 30 (refer to FIG. 2).

The projecting part 48 is provided with the vents 50 thereby to function as a part of the intake structure of the electronic apparatus 10. The vents 50 are provided in the vertical wall 48a on the Y1 side. Each of the vents 50 consists of, for example, a plurality of (three in FIG. 4) openings 50a closely arranged in the X-direction. The openings 50a are, for example, holes having substantially L-shaped cross sections that continue from the vertical wall 48a to the cover member 21 (refer to FIG. 4 and FIG. 6). The openings 50a may be formed only in the vertical wall 48a and may not extend to the cover member 21. The vents 50 are provided in a pair, and are located on the Y1 side of the left and right fans 30, 30 in the X-direction. The vents 50 are provided in the vicinity of the left and right ends of the vertical wall 48a. Neither of the fans 30 has a discharge port in a side surface 30f on the Y1 side, which faces the vent 50.

As illustrated in FIG. 6 and FIG. 7, the end surface 30d, in which the suction ports 35 of each of the fans 30 are formed, faces an inner space 48c of the projecting part 48. Hereinafter, the end surface 30d may be referred to as the "suction surface 30d." The inner space 48c is a groove-shaped space that is deeper on the Z2 side by the height of the projecting part 48 from an inner surface 21a of the cover member 21 that forms the bottom surface 12c. In other words, the inner space 48c expands the internal space of the chassis 12 in the Z-direction.

The suction surface 30d is a surface facing the Z2 side, and placed so as to cover the upper part of the inner space 48c. This enables the fans 30 to smoothly draw, into the suction ports 35, the air outside the chassis 12 passing through the vents 50 provided in the vertical wall 48a. Preferably, a part of each of the fans 30 in the thickness direction, i.e., the suction surface 30d, is inserted in the inner space 48c.

The depth of the inner space 48c, i.e., the height in the Z2 direction from the inner surface 21a of the cover member 21 to an inner bottom surface 48d of the projecting part 48, can be set to, for example, approximately 2.5 to 4 mm. The height in the Z2 direction from the inner surface 21a to the suction surface 30d can be set to, for example, approximately 0.5 to 1.5 mm. At this time, a gap of 1 mm or more is preferably secured between the suction surface 30d and the inner bottom surface 48d. This enables the fans 30 to more smoothly draw in, through the suction ports 35, the air that has been introduced into the inner space 48c through the vents 50. In addition, the presence of the inner space 48c immediately below the fans 30 makes it possible to increase the thicknesses of the fans 30, thereby increasing the air volume of the fans 30. The suction surface 30d may be positioned on the Z1 side beyond the inner surface 21a.

Input/output ports 54 can be provided at each of the longitudinal ends (left and right end surfaces) of the projecting part 48. Examples of the input/output ports 54 include those conforming to the HDMI (registered trademark) standard and those conforming to the USB 3.0 communication standard. Thus, the electronic apparatus 10 can have the tapered surfaces 56a on the side walls 56 while allowing the installation of the input/output ports 54 that require a certain height, as will be described later. The projecting part 48 also functions as a rear leg that raises the rear of the chassis 12 higher than the front when the chassis 12 is placed on a placing surface such as the top surface of a desk. This allows the keyboard device 18 of the electronic apparatus 10 to be inclined downward to the front when in use, thus improving operability. Symbol 55 in FIG. 3 to FIG. 7 denotes a rubber leg that serves as a leg when the electronic apparatus 10 is placed on a placing surface. The rubber legs 55 on the Y2 side are provided on a bottom surface 48e of the projecting part 48.

The intake structure of the electronic apparatus 10 can be provided with intake ports 58 formed in the vertical walls 20B (the side walls 56) of the side edges (the edges on the X1 and X2 sides) of the chassis 12. The intake ports 58 are openings for introducing the air from outside the chassis 12 into the suction ports 35 of the fans 30.

The left and right side walls 56 extend in the Y-direction orthogonal to the X-direction, which is the longitudinal direction of the outer wall 38. Each of the side walls 56 has a vertical surface along the Z-direction, which forms the outer periphery of the chassis 12, and a tapered surface 56a, which gradually inclines from the vertical surface to the center of the chassis 12 toward the Z2 side. Each of the intake ports 58 is provided in the tapered surface 56a of each of the side walls 56. Each of the intake ports 58 consists of, for example, a plurality of (two in FIG. 3) openings 58a arranged closely in the Y-direction. The left and right intake ports 58 are positioned on the opposite side from the exhaust ports 40 and 42 with respect to the fans 30 when the longitudinal direction (the Y-direction) of the side walls 56 is used as the reference. In other words, the intake ports 58 are located at the front (on the Y1 side) relative to the fans 30.

Providing the fans 30 with the suction ports 35 also in the end surface 30d on the Z1 side as well as the end surface 30c on the Z2 side enables the fans 30 to more smoothly draw in air from outside the chassis 12 also through the intake ports 58 provided in the side walls 56.

A description will now be given of the cooling action of the cooling module 24. The chain-line arrows shown in FIG. 2 to FIG. 7 schematically illustrate the flows of air.

In the electronic apparatus 10, the heat generated from a heat generating element such as the CPU 25a is transmitted to the metal plate 27 so as to be diffused, and is efficiently transported to the left and right heat sinks 29 through the heat pipes 28. The left and right fans 30 draw outside air (cool air) into the suction ports 35 through the vents 50 of the projecting part 48 as the intake ports, and discharge the air through the discharge ports 34a and 34b. The fans 30 can draw in outside air (cool air) also through the intake ports 58.

The air discharged through the discharge ports 34a of the left and right fans 30 passes the heat sinks 29 so as to be cooled. The air (hot air) that has been cooled is exhausted to the outside of the chassis 12 through the exhaust ports 42, which open at the left and right ends of the outer wall 38. At the same time, the air discharged through the discharge ports 34b of the left and right fans 30 flows along the surface of the metal plate 27 to cool the metal plate 27 and the heat pipes 28, and directly cools the electronic components of the CPU 25a at the same time. The air (hot air) that has been cooled is exhausted to the outside of the chassis 12 through the exhaust port 40, which opens at the center of the outer wall 38.

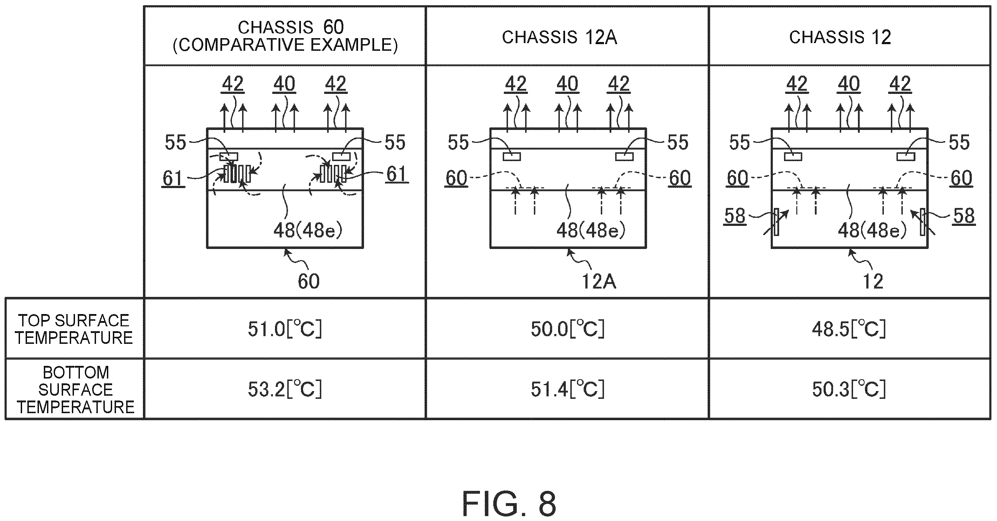

The operation and effect of the electronic apparatus 10 of the present embodiment will now be described with reference to FIG. 8.

FIG. 8 is a table illustrating the results of simulation experiments comparing the cooling performance of an electronic apparatus and the surface temperature of a chassis when cooling modules having different configurations are mounted in the chassis.

Referring to FIG. 8, the right column "Chassis 12" shows the experimental results obtained when the cooling module 24 is installed in the above-described chassis 12. The middle column "Chassis 12A" shows the experimental results obtained when the cooling module 24 is installed in a chassis 12A according to a modified example in which the intake ports 58 have been omitted from the above-described chassis 12. The left column "Chassis 60" shows the experimental results of a comparative example having the cooling module 24 installed in a chassis 60, in which the intake ports 58 and the vents 50 have been omitted from the above-described chassis 12, and instead, intake ports 61 have been formed in a bottom surface 48e of a projecting part 48. The intake ports 61 are located at positions where the intake ports 61 vertically overlap the fans 30.

Referring to FIG. 8, "Top surface temperature" indicates the temperature (°C) of a high-temperature part on the surface 12a of the chassis 12. "Bottom surface temperature" indicates the temperature (°C) of a high-temperature part on the bottom surface 12c of the chassis 12.

It has been found from the experiment results that the top surface temperature and the bottom surface temperature in the chassis 12 and 12A of the present embodiment are lower, as compared with the chassis 60 of the comparative example. This means that, in the electronic apparatus 10 of the present embodiment, to which the chassis 12 or the chassis 12A has been applied, the temperatures of the keyboard device 18 and the surface 12a of the surroundings thereof, which are frequently hand-touched directly by an operator, are reduced. Further, in the electronic apparatus 10 of the present embodiment, the temperature of the bottom surface 12c, which may come in contact with an operator's lap or the like, is also reduced. The chassis 12, in particular, showed results indicating that the top surface temperature and the bottom surface temperature further reduce, as compared with the chassis 12A. Thus, it has been verified that the usability of the electronic apparatus 10 is improved.

In addition, the electronic apparatus 10 of the present embodiment does not have openings of intake ports formed in the bottom surfaces 12c and 48e of the chassis 12 and 12A. Therefore, the electronic apparatus 10 including the chassis 12 or 12A shows the substantially flat bottom surfaces 12c and 48e with no openings when, for example, the electronic apparatus 10 is carried or used in an upright position, thus improving the appearance quality.

As described above, the electronic apparatus 10 of the present embodiment includes the fans 30, which are provided in the chassis 12 (12A) and have the suction surfaces 30d with the suction ports 35 formed therein. The chassis 12 (12A) has the projecting part 48, which is provided in such a manner as to protrude from the bottom surface 12c and extend along the width direction (the X-direction). The projecting part 48 has the vertical wall 48a, which extends along the longitudinal direction (the X-direction) thereof. The vertical wall 48a has the vents 50 formed therein. The suction surfaces 30d of the fans 30 are placed, facing the inner space 48c of the projecting part 48.

Thus, in the electronic apparatus 10, the suction surfaces 30d of the fans 30 are placed in such a manner as to face the inner space 48c of the projecting part 48 provided on the bottom surface 12c of the chassis 12 (12A). Further, the vertical wall 48a of the projecting part 48 has intake ports (vents 50) formed therein to introduce outside air into the suction surfaces 30d. Thus, there is no need to form openings in the bottom surfaces 12c and 48e in the chassis 12 (12A), making it possible to improve the appearance quality. Furthermore, high cooling capacity is ensured by providing the vents 50 in the vertical wall 48a of the projecting part 48 having the inner space 48c, to which the suction surfaces 30d of the fans 30 are exposed. As a result, the electronic apparatus 10 can also reduce the surface temperature of the chassis 12 (12A), as compared with the configuration in which the intake ports are provided in the bottom surface 48e as illustrated in FIG. 8.

In other words, providing the projecting part 48 enables the electronic apparatus 10 to achieve a high-quality design with no holes provided in the bottom surfaces 12c and 48e. On the other hand, the electronic apparatus 10 does not have holes in the bottom surfaces 12c and 48e, posing the problem of ports for introducing outside air into the fans 30 (the intake ports). As a solution to this, the electronic apparatus 10 has the vents 50 provided in the projecting part 48 where the suction surfaces 30d of the fans 30 face the inner space 48c. With this arrangement, the distance between the suction ports 35 of the fans 30 and the vents (the intake ports) 50 in the electronic apparatus 10 is extremely short, and the suction volume and the air volume of the fans 30 are increased, thus improving the cooling capacity.

Preferably, the fans 30 are installed at the positions where the fans 30 vertically overlap the projecting part 48, and a part thereof in the thickness direction (the Z-direction) is placed inside the inner space 48c of the projecting part 48. This makes it possible to install the fans 30 having a sufficient thickness despite the chassis 12 (12A) that has been made thinner, thus further improving the cooling capacity. Specifically, the fans 30 can more smoothly draw in, through the suction ports 35, the air introduced into the inner space 48c through the vents 50, resulting in a high cooling capacity as illustrated in FIG. 8. In this case, a predetermined gap should be secured between the suction surfaces 30d and the inner bottom surface 48d of the projecting part 48. This further improves the efficiency of suction from the vents 50 through the suction ports 35.

The chassis 12 (12A) has the outer wall 38 in which the exhaust ports 40 and 42 are formed and which extends in the longitudinal direction of the projecting part 48. The projecting part 48 is preferably placed immediately in front of the outer wall 38. With this arrangement, the projecting part 48 is placed in the vicinity of the rear end of the bottom surface 12c in the electronic apparatus 10, thus improving the design coherence on the bottom surface 12c side with resultant further improved appearance quality.

In the chassis 12, each of the left and right side walls 56 can have the intake port 58. This leads to an increased suction volume of the fans 30 with a resultant increased discharge air volume, thus further improving the cooling capacity of the cooling module 24.

It is needless to say that the present invention is not limited to the embodiment described above, and modifications can be freely made within the scope not departing from the gist of the present invention. Description of Symbols
- 10: electronic apparatus
- 11: cover body
- 12, 12A: chassis
- 16: display
- 18: keyboard device
- 24: cooling module
- 25: motherboard
- 25a: CPU
- 27: metal plate
- 28: heat pipe
- 29: heat sink
- 30: fan
- 34a, 34b: discharge port
- 35: suction port
- 38: outer wall
- 40, 42: exhaust port
- 48: projecting part
- 48c: inner space
- 50: vent

## Claims

1. An electronic apparatus (10) comprising:
a chassis (12, 12A); and
a fan (30) which is provided in the chassis and comprises a suction surface (30d) with a suction port (35) formed therein,
wherein the chassis comprises a projecting part (48) which is arranged to protrude from a bottom surface (12c) of the chassis and extends along a width direction,
the projecting part comprises at least one vertical wall (48a, 48b) which extends along a longitudinal direction thereof, at least one of the vertical walls comprising a vent formed therein, and
the suction surface is arranged to face an inner space (48c) of the projecting part.

2. The electronic apparatus according to claim 1, wherein the fan is arranged at a position where the fan vertically overlaps the projecting part, and a part thereof in a thickness direction is arranged inside the inner space of the projecting part.

3. The electronic apparatus according to claim 2, wherein a gap is provided between the suction surface and an inner bottom surface (48d) of the projecting part.

4. The electronic apparatus according to any one of claims 1 to 3,
wherein the chassis comprises an outer wall (38) which comprises an exhaust port (40, 42) formed therein, and extends along a longitudinal direction of the projecting part, and
the projecting part is arranged immediately in front of the outer wall.

5. The electronic apparatus according to claim 4, further including:
a cover body (11) with a display (16) mounted thereon, and
a hinge (14) configured to connect the cover body to one edge portion of the chassis provided with the outer wall such that the cover body is rotatable relative to the one edge portion.

6. The electronic apparatus according to claim 5, wherein the chassis comprises a pair of side walls (56) which extend in a direction orthogonal to the outer wall, and comprise at least one intake port (58) formed therein, and
the at least one intake ports are arranged on an opposite side from the outer wall with respect to the projecting part in the case where a longitudinal direction of the side walls is used as a reference.
